(19) Europäisches Patentamt / European Patent Office / Office européen des brevets

(11) **EP 4 614 603 A1**

(12) **EUROPEAN PATENT APPLICATION**
published in accordance with Art. 153(4) EPC

(43) Date of publication:
**10.09.2025 Bulletin 2025/37**

(21) Application number: **24843420.1**

(22) Date of filing: **11.07.2024**

(51) International Patent Classification (IPC):
$H01M\ 4/38$ (2006.01)   $H01M\ 4/62$ (2006.01)
$H01M\ 4/131$ (2010.01)   $H01M\ 10/052$ (2010.01)
$H01M\ 4/134$ (2010.01)   $H01M\ 4/02$ (2006.01)

(52) Cooperative Patent Classification (CPC):
Y02E 60/10

(86) International application number:
**PCT/KR2024/009931**

(87) International publication number:
**WO 2025/018702 (23.01.2025 Gazette 2025/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.07.2023 KR 20230091763**

(71) Applicant: **LG Energy Solution, Ltd.**
**Seoul 07335 (KR)**

(72) Inventors:
• **KIM, Nayeong**
**Daejeon 34122 (KR)**

• **KIM, Dohyeun**
**Daejeon 34122 (KR)**
• **KIM, Donghyuk**
**Daejeon 34122 (KR)**
• **LEE, Yong Ju**
**Daejeon 34122 (KR)**
• **JUN, Hyunmin**
**Daejeon 34122 (KR)**

(74) Representative: **Hoffmann Eitle**
**Patent- und Rechtsanwälte PartmbB**
**Arabellastraße 30**
**81925 München (DE)**

(54) **NEGATIVE ELECTRODE ACTIVE MATERIAL, METHOD FOR PREPARING NEGATIVE ELECTRODE ACTIVE MATERIAL, NEGATIVE ELECTRODE COMPOSITION, NEGATIVE ELECTRODE COMPRISING SAME FOR LITHIUM SECONDARY BATTERY, AND LITHIUM SECONDARY BATTERY COMPRISING NEGATIVE ELECTRODE**

(57)    The present application relates to a negative electrode active material, a method for preparing a negative electrode active material, a negative electrode composition, a negative electrode comprising same for a lithium secondary battery, and a lithium secondary battery comprising the negative electrode, the negative electrode active material comprising a silicon-based active material, which is a mixture of silicon-based particles and a binder, wherein the silicon-based particles have a grain size of 100 nm or less, the particle size (D50) of the silicon-based active material is 1 to 20 $\mu$m, and the binder is contained in a content of 1 to 15 parts by weight relative to 100 parts by weight of the silicon-based active material.

[Figure 1]

**Description**

[Technical Field]

The present application claims priority to and the benefit of Korean Patent Application No. 10-2023-0091763 filed in the Korean Intellectual Property Office on July 14, 2023, the entire contents of which are incorporated herein by reference.

The present application relates to a negative electrode active material, a method for manufacturing a negative electrode active material, a negative electrode composition, a negative electrode for a lithium secondary battery including the same, and a lithium secondary battery including a negative electrode.

[Background Art]

Due to the rapid increase in the use of fossil fuels, the demand for the use of alternative energy or clean energy is increasing, and as part thereof, the fields that are being studied most actively are the fields of power generation and power storage using an electrochemical reaction.

At present, a secondary battery is a representative example of an electrochemical device that utilizes such electrochemical energy, and the range of use thereof tends to be gradually expanding.

Along with the technology development and increased demand for mobile devices, demand for secondary batteries as energy sources is increasing sharply. Among such secondary batteries, lithium secondary batteries having high energy density and voltage, long cycle life and low self-discharging rate have been commercialized and widely used. In addition, research is being actively conducted on a method for manufacturing a high-density electrode having a higher energy density per unit volume as an electrode for such a high-capacity lithium secondary battery.

In general, a secondary battery includes a positive electrode, a negative electrode, an electrolyte, and a separator. The negative electrode includes a negative electrode active material for intercalating and deintercalating lithium ions coming out from the positive electrode, and silicon-based particles having a high discharge capacity may be used as the negative electrode active material.

In particular, according to the demand for high density energy batteries in recent years, research is being actively conducted on a method for increasing a capacity by using together a silicon-based compound such as Si/C and SiOx having a capacity 10 times or higher than that of a graphite-based material, as a negative electrode active material. However, as compared with graphite that is typically used, a silicon-based compound that is a high-capacity material has a large capacity but undergoes rapid volume expansion during charging, thereby disconnecting a conductive path to degrade battery characteristics.

Accordingly, in order to address a problem occurring when the silicon-based compound is used as the negative electrode active material, methods of suppressing the volume expansion itself such as a method of controlling a driving potential, a method of additionally further coating a thin film on an active material layer and a method of controlling a particle diameter of a silicon-based compound, or various methods for preventing a conductive path from being disconnected have been discussed. However, the above methods may rather deteriorate the performance of a battery, and thus, the application thereof is limited, so that there is still a limitation in commercializing the manufacture of a battery including a negative electrode having a high content of a silicon-based compound.

In addition, as a result of research on the aforementioned problem, it was found that the smaller the crystal grain size of the silicon-based active material, the higher the life performance. However, as the crystal grain size of the silicon-based active material is made smaller to improve the life performance, there arise problems in that the coating condition on the electrode deteriorates, and also, the electrode adhesion decreases, resulting in problems such as detachment from the negative electrode current collector during evaluation of the cell life performance.

Therefore, there is a need for research on a method that can address the above-mentioned problems, when using a silicon-based active material as a negative electrode active material so as to improve capacity performance.

Citation List

Patent Literature

Japanese Patent Application Publication No. 2009-080971

[Detailed Description of the Invention]

[Technical Problem]

As a result of research on a method capable of improving the life performance of a negative electrode including a silicon-based active material, it was found that when nano-sized silicon-based particles used in the related art are mixed with a binder to form secondary particles, the binder acts as a buffer and mitigates the particle pulverization phenomenon.

Accordingly, the present application relates to a negative electrode active material, a method for manufacturing a negative electrode active material, a negative electrode composition, a negative electrode for a lithium secondary battery including the same, and a lithium secondary battery including a negative electrode capable of addressing the above-described problems.

[Technical Solution]

An exemplary embodiment of the present specification provides a negative electrode active material including a silicon-based active material, wherein the silicon-based active material is a mixture of silicon-based particles and a binder, the silicon-based particles have a crystal grain size of 100 nm or less, a particle size (D50) of the silicon-based active material is 1 $\mu$m or greater and 20 $\mu$m or less, and the binder is included in an amount of 1 part by weight or more and 15 parts by weight or less based on 100 parts by weight of the silicon-based active material.

Another exemplary embodiment provides a method for manufacturing a negative electrode active material, the method including: preparing a silicon raw material; pulverizing the silicon raw material to form silicon-based particles; and mixing the silicon-based particles with a solvent and a binder to form a silicon-based active material, wherein the silicon-based particles have a crystal grain size of 100 nm or less, a particle size (D50) of the silicon-based active material is 1 $\mu$m or greater and 20 $\mu$m or less, and the binder is included in an amount of 1 part by weight or more and 15 parts by weight or less based on 100 parts by weight of the silicon-based active material.

Still another exemplary embodiment provides a negative electrode composition including: the negative electrode active material according to the present application; a negative electrode conductive material; and a negative electrode binder.

Still yet another exemplary embodiment provides a negative electrode for a lithium secondary battery including: a negative electrode current collector layer; and a negative electrode active material layer provided on one surface or both surfaces of the negative electrode current collector layer, wherein the negative electrode active material layer includes the negative electrode composition according to the present application or a cured product thereof.

Finally, there is provided a lithium secondary battery including a positive electrode; the negative electrode for a lithium secondary battery according to the present application; a separator provided between the positive electrode and the negative electrode; and an electrolyte.

[Advantageous Effects]

The negative electrode active material according to an exemplary embodiment of the present invention includes a spherical silicon-based active material with a micro-sized particle size, formed by mixing nano-sized silicon-based particles with a binder.

That is, the silicon-based active material is a mixture of silicon-based particles and a binder, wherein the silicon-based particles have a crystal grain size of 100 nm or less, and the particle size (D50) of the silicon-based active material is within the range of 1 $\mu$m or greater and 20 $\mu$m or less, thereby addressing problems related to life performance and facilitating electrode manufacturing.

In addition, the binder constituting the secondary particles (a mixture of silicon-based particles and a binder) is included in an amount of 1 part by weight or more and 15 parts by weight or less based on 100 parts by weight of the silicon-based active material, thereby serving as a buffer within the silicon-based active material and further mitigating the particle pulverization phenomenon compared to micro-sized polycrystalline particles.

[Brief Description of Drawings]

FIG. 1 is a view showing a stack structure of a negative electrode for a lithium secondary battery according to an exemplary embodiment of the present application.

FIG. 2 is a view showing a stack structure of a lithium secondary battery according to an exemplary embodiment of the present application.

<Explanation of Reference Numerals and Symbols>

10:    negative electrode current collector layer
20:    negative electrode active material layer
30:    separator
40:    positive electrode active material layer
50:    positive electrode current collector layer
100:   negative electrode for lithium secondary battery
200:   positive electrode for lithium secondary battery

[Best Mode]

Before describing the present invention, some terms are first defined.

When one part "includes", "comprises" or "has" one constituent element in the present specification, unless otherwise specifically described, this does not mean that another constituent element is excluded, but means that another constituent element may be further included.

In the present specification, 'p to q' means a range of 'p or more and q or less'.

In the present specification, the "specific surface area" is measured by the BET method, and specifically, is calculated from a nitrogen gas adsorption amount at a liquid nitrogen temperature (77K) by using BELSORP-mini II available from BEL Japan, Inc. That is, in the present application, the BET specific surface area may refer to the specific surface area measured by the above measurement method.

In the present specification, **"Dn"** refers to a particle size distribution, and refers to a particle diameter at the n% point in the cumulative distribution of the number of particles according to the particle diameter. That is, D50 is a particle diameter (average particle diameter) at the 50% point in the cumulative distribution of the number of particles according to the particle diameter, D90 is a particle diameter at the 90% point in the cumulative distribution of the number of particles according to the particle diameter, and D10 is a particle diameter at the 10% point in the cumulative distribution of the number of particles according to the particle diameter. Meanwhile, the average particle diameter may be measured using a laser diffraction method. Specifically, after powder to be measured is dispersed in a dispersion medium, the resultant dispersion is introduced into a commercially available laser diffraction particle size measurement apparatus (for example, Microtrac S3500) in which a difference in a diffraction pattern according to the particle size is measured, when a laser beam passes through particles, and then a particle size distribution is calculated.

In an exemplary embodiment of the present application, the particle size or particle diameter may mean an average diameter or representative diameter of each crystal grain constituting the metal powder.

In the present specification, the description **"a** polymer includes a certain monomer as a monomer unit" means that the monomer participates in a polymerization reaction and is included as a repeating unit in the polymer. In the present specification, when a polymer includes a monomer, this is interpreted to be the same as when the polymer includes a monomer as a monomer unit.

In the present specification, it is understood that the term 'polymer' is used in a broad sense including a copolymer unless otherwise specified as 'a homopolymer'.

In the present specification, a weight-average molecular weight (Mw) and a number-average molecular weight (Mn) are polystyrene converted molecular weights measured by gel permeation chromatography (GPC) while employing, as a standard material, a monodispersed polystyrene polymer (standard sample) having various degrees of polymerization commercially available for measuring a molecular weight. In the present specification, a molecular weight refers to a weight-average molecular weight unless particularly described otherwise.

Hereinafter, embodiments of the present invention will be described in detail with reference to the drawings so that one skilled in the art can readily implement the present invention. However, the present invention may be embodied in various different forms, and is not limited to the following descriptions.

An exemplary embodiment of the present specification provides a negative electrode active material including a silicon-based active material, wherein the silicon-based active material is a mixture of silicon-based particles and a binder, the silicon-based particles have a crystal grain size of 100 nm or less, a particle size (D50) of the silicon-based active material is 1 $\mu$m or greater and 20 $\mu$m or less, and the binder is included in an amount of 1 part by weight or more and 15 parts by weight or less based on 100 parts by weight of the silicon-based active material.

In an exemplary embodiment of the present application, the silicon-based active material includes a binder. Accordingly, for example, when nano-sized silicon-based particles are mixed with the binder and composited in the form of secondary particles, the volume expansion can be efficiently controlled compared to a case where the silicon-based active material does not include a binder and is not composited, thereby enabling a higher content of negative electrode active material to be included. In addition, the binder acts as a buffer to mitigate the particle pulverization phenomenon, which is also effective in increasing the content of Si active material in the electrode.

The negative electrode active material according to an exemplary embodiment of the present invention includes a spherical silicon-based active material with a micro-sized particle size, formed by mixing nano-sized silicon-based particles with a binder. That is, the silicon-based active material is a mixture of silicon-based particles and a binder, wherein the silicon-based particles have a crystal grain size of 100 nm or less, and the particle size (D50) of the silicon-based active material is within the range of 1 $\mu$m or greater and 20 $\mu$m or less, thereby addressing problems related to life performance and facilitating electrode manufacturing.

In an exemplary embodiment of the present application, the silicon-based active material may include one or more selected from the group consisting of $SiO_x$ (x=0), $SiO_x$ (0<x<2) and SiC.

In an exemplary embodiment of the present application, the silicon-based active material may include one or more selected from the group consisting of $SiO_x$ (x=0) and $SiO_x$ (0<x<2), and may include the $SiO_x$ (x=0) in an amount of 70 parts by weight or more based on 100 parts by weight of the silicon-based active material.

In an exemplary embodiment of the present application, the silicon-based active material may include $SiO_x$ (x=0), and include 70 parts by weight or more of $SiO_x$ (x=0) on the basis of 100 parts by weight of the silicon-based active material.

In an exemplary embodiment of the present application, the silicon-based active material may further include $SiO_x$ (0<x<2).

In another exemplary embodiment, $SiO_x$ (x=0) may be included in an amount of 70 parts by weight or more, preferably 80 parts by weight or more, and more preferably 90 parts by weight or more, and 100 parts by weight or less, preferably 99 parts by weight or less, and more preferably 95 parts by weight or less based on 100 parts by weight of the silicon-based active material.

In an exemplary embodiment of the present application, pure silicon (Si) particles may be particularly used as the silicon-based active material. The use of pure silicon (Si) particles as the silicon-based active material may mean that, on the basis of 100 parts by weight of the total silicon-based active material as described above, pure Si particles ($SiO_x$ (x=0)) not bonded to other particles or elements are included within the above range.

In an exemplary embodiment of the present application, the silicon-based active material may be formed of silicon-based particles having 100 parts by weight of $SiO_x$ (x=0) on the basis of 100 parts by weight of the silicon-based active material.

In an exemplary embodiment of the present application, the silicon-based active material may include a metal impurity, and in this case, the impurity is metal that may be generally included in the silicon-based active material, and specifically, a content thereof may be 0.1 part by weight or less on the basis of 100 parts by weight of the silicon-based active material.

Note that, in an exemplary embodiment of the present application, the particle size, i.e., an average particle diameter (D50) of the silicon-based active material may be 1 $\mu$m or greater and 20 $\mu$m or less, 5 $\mu$m to 10 um, specifically 5 $\mu$m to 8 $\mu$m, and more specifically 5 $\mu$m to 7 $\mu$m. If the average particle diameter is less than 5 $\mu$m, the specific surface area of the particle increases excessively, causing the viscosity of the negative electrode slurry to increase excessively. Accordingly, the particles constituting the negative electrode slurry are not smoothly dispersed. In addition, if the silicon-based active material is excessively small, a contact area between the silicon-based particles and a conductive material is reduced due to the composite composed of the conductive material and the binder in the negative electrode slurry, so that a possibility of disconnection of the conductive network increases, thereby lowering the capacity retention rate. On the other hand, if the average particle diameter is greater than 10 $\mu$m, excessively large silicon-based particles are present, so that the surface of the negative electrode is not smooth, causing current density unevenness during charging and discharging. Additionally, if the silicon-based particles are excessively large, the phase stability of the negative electrode slurry becomes unstable, resulting in degraded processability. As a result, the capacity retention rate of the battery decreases.

In an exemplary embodiment of the present application, the silicon-based active material generally has a characteristic BET specific surface area. The BET specific surface area of the silicon-based active material is preferably 0.01 $m^2$/g to 150.0 $m^2$/g, more preferably 0.1 $m^2$/g to 100.0 $m^2$/g, particularly preferably 0.2 $m^2$/g to 80.0 $m^2$/g, and most preferably 0.2 $m^2$/g to 18.0 $m^2$/g. The BET specific surface area is measured in accordance with DIN 66131 (using nitrogen).

In an exemplary embodiment of the present application, the silicon-based active material may be present, for example, in a crystalline or amorphous form, and is preferably not porous. The silicon particles are preferably spherical or fragment-shaped particles. Alternatively, but less preferably, the silicon particles may also have a fiber structure or be present in the form of a silicon-containing film or coating.

In an exemplary embodiment of the present application, the silicon-based active material may have a non-spherical shape, and its sphericity (circularity) is, for example, 0.9 or less, for example, 0.7 to 0.9, for example 0.8 to 0.9, and for example 0.85 to 0.9.

In the present application, the circularity is determined by Formula 1 below, in which A is an area and P is a boundary line.

$$[\text{Formula 1}]$$

$$4\pi A/P^2$$

The capacity of the silicon-based active material is significantly higher than that of a graphite-based active material that is typically used, so that there have been more attempts to apply the same. However, the volume expansion rate of the silicon-based active material during charging and discharging is high, so that, for example, only a small amount thereof is mixed and used with a graphite-based active material.

Therefore, in the present invention, only the silicon-based active material is used as a negative electrode active material in order to improve capacity performance, and at the same time, in order to address the problems as described above, rather than controlling the compositions of the conductive material and the binder, the silicon-based active material is manufactured in the form of secondary particles, thereby addressing the problems found in the related art.

In an exemplary embodiment of the present application, the silicon-based active material is in the form of secondary particles, which are a mixture of silicon-based particles and a binder.

That is, the silicon-based active material includes silicon-based particles as primary particles and may be composed of secondary particles, which are a mixture of primary particles and a binder.

In an exemplary embodiment of the present application, the silicon-based particles may have a crystal grain size of 100 nm or less.

In an exemplary embodiment of the present application, the silicon-based particles may have the crystal grain size of 10 nm or greater and 80 nm or less.

In another exemplary embodiment, the silicon-based particles may have the crystal grain size of 100 nm or less, 95 nm or less, 90 nm or less, or 80 nm or less, and 1 nm or greater, 5 nm or greater, 7 nm or greater, or 10 nm or greater.

In still another exemplary embodiment, the silicon-based particles may have the crystal grain size of 10 nm or greater 80 nm or less.

The silicon-based particles have the crystal grain size within the range, leading to widely distributed crystal grain boundaries. As a result, the lithium ions can be uniformly intercalated during intercalating of lithium ions, thereby reducing the stress applied during intercalating of lithium ions into the silicon particles, and accordingly, mitigating breakage of the particles. As a result, characteristics capable of improving the life stability of the negative electrode are obtained. If the crystal grain size exceeds the above range, the crystal grain boundaries within the particles are narrowly distributed, and in this case, lithium ions are non-uniformly intercalated into the particles, leading to large stress during the intercalating of ions, and accordingly, breakage of particles.

In the present application, the crystal grain refers to a crystal particle in a metal or material, which is a collection of microscopically irregular shapes, and the crystal grain size may mean a diameter of the observed crystal grain particle. That is, in the present application, the crystal grain size means a size of a domain sharing the same crystal direction in a particle, and has a different concept from a particle size or a size of a particle diameter expressing a size of a material.

In an exemplary embodiment of the present application, the crystal grain size can be calculated as a value of full width at half maximum (FWHM) through XRD analysis. The remaining values except L are measured through XRD analysis of the silicon-based active material, and the crystal grain size can be measured through the Debey-Scherrer equation showing that the FWHM and the crystal grain size are in inverse ratio. The Debey-Scherrer Formula is as shown in Formula 1-1 below.

$$[\text{Formula 1-1}]$$

$$FWHM = K\lambda/L\cos\theta$$

in Equation 1-1,

L is the crystal grain size, K is a constant, $\theta$ is a Bragg angle, and $\lambda$ means a wavelength of X-ray.

In addition, the shapes of the crystal grains are diverse and can be measured in three dimensions. In general, the size of the crystal grain can be measured by a generally used circle method or diameter measurement method, but the present invention is not limited thereto.

In the diameter measurement method, the size of the crystal grain can be measured by drawing 5 to 10 parallel lines each having a length of L mm on a micrograph of a target particle, counting the number of crystal grains z on each line, and averaging them. In this case, only crystal grains that are wholly included on the line are counted, and crystal grains that are partially put (laid across) on the line are excluded. When the number of lines is P and the magnification is V, the average particle diameter can be calculated by Formula 1-2 below.

$$[Formula\ 1-2]$$

$$Dm\ =\ (L*P*10^3)/(zV)\ (\mu m)$$

The circle method is a method in which a circle with a predetermined diameter is drawn on a micrograph of a target particle, and then an average area of crystal grains is calculated by the number of crystal grains in the circle and the number of crystal grains laid across the boundary line, and the average area can be calculated by Formula 1-3 below.

$$[Formula\ 1-3]$$

$$Fm\ =\ (Fk\ *\ 10^6)\ /\ ((0.67n\ +\ z)\ V^2)\ (\mu m^2)$$

In Formula 1-3, Fm is an average particle area, Fk is a measurement area on the photograph, z is the number of particles in a circle, n is the number of particles laid across the circle, and V is a magnification of a microscope.

In an exemplary embodiment of the present application, there is provided the negative electrode active material in which the silicon-based particles are single-crystal silicon-based particles or polycrystalline silicon-based particles.

In an exemplary embodiment of the present application, the silicon-based particles may be single-crystal silicon-based particles.

In an exemplary embodiment of the present application, the silicon particles may be polycrystalline silicon-based particles.

In an exemplary embodiment of the present application, the silicon-based active material is in the form of secondary particles, which are a mixture of silicon-based particles and a binder. In this case, the binder serves to form secondary particles by mixing silicon-based particles, which are primary particles, with each other.

In an exemplary embodiment of the present application, there is provided the negative electrode active material in which the binder is a binder having a linear chain structure.

In an exemplary embodiment of the present application, there is provided the negative electrode active material in which the binder includes an aqueous binder, and the aqueous binder includes one or more selected from the group consisting of polyvinylpyrrolidone (PVP), poly acrylic acid (PAA), and polyacrylamide (PAM).

In an exemplary embodiment of the present application, the binder may be included in an amount of 1 part by weight or more and 15 parts by weight or less based on 100 parts by weight of the silicon-based active material.

In another exemplary embodiment, the binder may be included in an amount of 1 part by weight or more and 15 parts by weight or less, preferably 3 parts by weight or more and 15 parts by weight or less, and more preferably 5 parts by weight or more and 15 parts by weight or less based on 100 parts by weight of the silicon-based active material.

The binder satisfies the range as described above. However, if the content of the binder exceeds the range, the capacity and life performance of the battery may deteriorate, and if the content falls below the range, the binder may not properly serve as a buffer, leading to a decrease in life performance due to the particle pulverization phenomenon.

In particular, if the content of the binder exceeds 15 parts by weight based on 100 parts by weight of the silicon-based active material, for example, if the binder included in the silicon-based active material exceeds the aforementioned range, the binder itself becomes a type of resistor, leading to a decrease in efficiency characteristics and a deterioration in energy density and capacity characteristics.

The binder according to an exemplary embodiment of the present application has a different composition from a negative electrode binder described below.

An exemplary embodiment of the present application provides a method for manufacturing a negative electrode active material, the method including the steps of: preparing a silicon raw material; pulverizing the silicon raw material to form silicon-based particles; and mixing the silicon-based particles with a solvent and a binder to form a silicon-based active material, wherein the silicon-based particles have a crystal grain size of 100 nm or less, a particle size (D50) of the silicon-based active material is 1 $\mu$m or greater and 20 $\mu$m or less, and the binder is included in an amount of 1 part by weight or more and 15 parts by weight or less based on 100 parts by weight of the silicon-based active material.

In the manufacturing method, each composition and content are the same as described above.

In the present application, there is provided the method for manufacturing a negative electrode active material further including the step of, after mixing the silicon-based particles with a solvent and a binder, drying the mixture.

In the present application, in the step of mixing the silicon-based particles with a solvent and a binder to form a silicon-based active material, a mixing rpm may be 2000 rpm or higher and 3000 rpm or less.

In the present application, the silicon raw material may be a raw material that is used when manufacturing a silicon active material in the art, and may include a lump of silicon, MG-Si, and the like.

In an exemplary embodiment of the present application, there is provided a negative electrode composition including the negative electrode active material described above, a negative electrode conductive material, and a negative electrode binder.

In an exemplary embodiment of the present application, there is provided the negative electrode composition in which the negative electrode active material is included in an amount of 40 parts by weight or more on the basis of 100 parts by weight of the negative electrode composition.

In another exemplary embodiment, the negative electrode active material may be included in an amount of 40 parts by weight or more, preferably 60 parts by weight or more, more preferably 65 parts by weight or more, and further preferably 70 parts by weight or more, and 95 parts by weight or less, preferably 90 parts by weight or less, and more preferably 85 parts by weight or less, on the basis of 100 parts by weight of the negative electrode composition.

The negative electrode composition according to the present application uses the negative electrode active material satisfying the specific surface area size capable of controlling the volume expansion rate during charging and discharging even when the negative electrode active material having a significantly high capacity is used within the above range. Accordingly, even when the negative electrode active material is within the above range, the negative electrode composition does not degrade the performance of the negative electrode and has excellent output characteristics in charging and discharging.

In the related art, it is general to use only graphite-based compounds as the negative electrode active material. However, in recent years, as the demand for high-capacity batteries is increasing, attempts to mix and use silicon-based active materials are increasing in order to increase capacity. However, in the case of a silicon-based active material, even when the characteristics of the silicon-based active material itself are adjusted as described above, the volume may rapidly expand during charging and discharging, thereby causing some problems of damaging the conductive path formed in the negative electrode active material layer.

Therefore, in an exemplary embodiment of the present application, the negative electrode conductive material may include one or more selected from the group consisting of a point-like conductive material, a planar conductive material and a linear conductive material.

In an exemplary embodiment of the present application, the point-like conductive material refers to a point-like or spherical conductive material that may be used for improving conductivity of the negative electrode, and has conductivity without causing a chemical change. Specifically, the point-like conductive material may be one or more selected from the group consisting of natural graphite, artificial graphite, carbon black, acetylene black, Ketjen black, channel black, furnace black, lamp black, thermal black, conductive fiber, fluorocarbon, aluminum powder, nickel powder, zinc oxide, potassium titanate, titanium oxide, and a polyphenylene derivative, and preferably may include carbon black in terms of high conductivity and excellent dispersibility.

In an exemplary embodiment of the present application, the point-like conductive material may have a BET specific surface area of 40 $m^2/g$ or greater and 70 $m^2/g$ or less, preferably 45 $m^2/g$ or greater and 65 $m^2/g$ or less, and more preferably 50 $m^2/g$ or greater and 60 $m^2/g$ or less.

In an exemplary embodiment of the present application, a content of the functional group (volatile matter) of the point-like conductive material may satisfy a range of 0.01% or more and 1% or less, preferably 0.01% or more and 0.3% or less, and more preferably 0.01% or more and 0.1% or less.

In particular, when the content of the functional group of the point-like conductive material satisfies the above range, a functional group is present on a surface of the point-like conductive material, so that the point-like conductive material can be smoothly dispersed in a solvent when water is used as the solvent. In particular, in the present invention, as the specific silicon-based active material is used, a functional group content of the point-like conductive material can be lowered, which exhibits an excellent effect in improving dispersibility.

In an exemplary embodiment of the present application, the point-like conductive material having the content of the functional group within the range described above is included together with the silicon-based active material, and the content of the functional group can be adjusted according to a degree of heat treatment of the point-like conductive material.

In an exemplary embodiment of the present application, a particle diameter of the point-like conductive material may be 10 nm to 100 nm, preferably 20 nm to 90 nm, and more preferably 20 nm to 60 nm.

In an exemplary embodiment of the present application, the conductive material may include a planar conductive material.

The planar conductive material improves conductivity by increasing surface contact between silicon-based particles in the negative electrode, and at the same time, can serve to suppress disconnection of the conductive path due to the volume expansion. The planar conductive material may be expressed as a plate-like conductive material or a bulk-type conductive material.

In an exemplary embodiment of the present application, the planar conductive material may include one or more selected from the group consisting of plate-like graphite, graphene, graphene oxide, and graphite flake, and preferably may be plate-like graphite.

In an exemplary embodiment of the present application, an average particle diameter (D50) of the planar conductive material may be 2 μm to 7 μm, specifically 3 μm to 6 μm, and more specifically 3.5 μm to 5 μm. When the above range is satisfied, the sufficient particle size results in easy dispersion without causing an excessive increase in viscosity of the negative electrode slurry. Therefore, the dispersion effect is excellent when dispersing using the same equipment and time.

In an exemplary embodiment of the present application, there is provided the negative electrode composition in which the planar conductive material has D10 of 0.5 μm or greater and 2.0 μm or less, D50 of 2.5 μm or greater and 3.5 μm or less, and D90 of 6.5 μm or greater and 15.0 μm or less.

In an exemplary embodiment of the present application, for the planar conductive material, a planar conductive material with a high specific surface area having a high BET specific surface area or a planar conductive material with a low specific surface area may be used.

In an exemplary embodiment of the present application, for the planar conductive material, a planar conductive material with a high specific surface area or a planar conductive material with a low specific surface area may be used without limitation. However, in particular, the planar conductive material according to the present application can be affected to some extent in the electrode performance by the dispersion effect, so that a planar conductive material with a low specific surface area that does not cause a problem in dispersion is used particularly preferably.

In an exemplary embodiment of the present application, the planar conductive material may have a BET specific surface area of 0.25 m$^2$/g or greater.

In another exemplary embodiment, the planar conductive material may have a BET specific surface area of 1 m$^2$/g or greater and 500 m$^2$/g or less, preferably 5 m$^2$/g or greater and 300 m$^2$/g or less, and more preferably 5 m$^2$/g or greater and 250 m$^2$/g or less.

For the planar conductive material of the present application, a planar conductive material with a high specific surface area or a planar conductive material with a low specific surface area may be used.

In another exemplary embodiment, the planar conductive material is a planar conductive material with a high specific surface area, and the BET specific surface area may satisfy a range of 50 m$^2$/g or greater and 500 m$^2$/g or less, preferably 80 m$^2$/g or greater and 300 m$^2$/g or less, and more preferably 100 m$^2$/g or greater and 300 m$^2$/g or less.

In another exemplary embodiment, the planar conductive material is a planar conductive material with a low specific surface area, and the BET specific surface area may satisfy a range of 1 m$^2$/g or greater and 40 m$^2$/g or less, preferably 5 m$^2$/g or greater and 30 m$^2$/g or less, and more preferably 5 m$^2$/g or greater and 25 m$^2$/g or less.

Other conductive materials may include linear conductive materials such as carbon nanotubes. The carbon nanotubes may be bundle-type carbon nanotubes. The bundle-type carbon nanotubes may include a plurality of carbon nanotube units. Specifically, the term 'bundle type' herein refers to, unless otherwise specified, a bundle or rope-shaped secondary shape in which a plurality of carbon nanotube units are aligned side by side in such an orientation that longitudinal axes of the carbon nanotube units are substantially the same, or are entangled. The carbon nanotube unit has a graphite sheet having a cylindrical shape with a nano-sized diameter, and has an sp2 bonding structure. In this case, the characteristics of a conductor or a semiconductor may be exhibited depending on the rolled angle and structure of the graphite sheet. As compared with entangled-type carbon nanotubes, the bundle-type carbon nanotubes can be more uniformly dispersed during the manufacture of the negative electrode, and can form more smoothly a conductive network in the negative electrode to improve the conductivity of the negative electrode.

In an exemplary embodiment of the present application, there is provided the negative electrode composition in which the negative electrode conductive material is included in an amount of 10 part by weight or more and 40 parts by weight or less based on 100 parts by weight of the negative electrode composition.

In another exemplary embodiment, the negative electrode conductive material may be included in an amount of 0.1 part by weight or more and 40 parts by weight or less, preferably 0.2 part by weight or more and 30 parts by weight or less, more preferably 0.4 part by weight or more and 25 parts by weight or less, and most preferably 0.4 part by weight or more and 10 parts by weight or less on the basis of 100 parts by weight of the negative electrode composition.

In an exemplary embodiment of the present application, there is provided the negative electrode composition in which the negative electrode conductive material includes a planar conductive material and a linear conductive material.

In an exemplary embodiment of the present application, there is provided the negative electrode composition in which the negative electrode conductive material includes 80 parts by weight or more and 99.9 parts by weight or less of the planar conductive material and 0.1 part by weight or more and 20 parts by weight or less of the linear conductive material on the basis of 100 parts by weight of the negative electrode conductive material.

In another exemplary embodiment, the negative electrode conductive material may include 80 parts by weight or more and 99.9 parts by weight or less, preferably 85 parts by weight or more and 99.9 parts by weight or less, and more preferably 95 parts by weight or more and 98 parts by weight or less of the planar conductive material based on 100 parts by weight of the negative electrode conductive material.

In another exemplary embodiment, the negative electrode conductive material may include 0.1 part by weight or more and 20 parts by weight or less, preferably 0.1 part by weight or more and 15 parts by weight or less, and more preferably 0.2 part by weight or more and 5 parts by weight or less of the linear conductive material based on 100 parts by weight of the negative electrode conductive material.

In an exemplary embodiment of the present application, the negative electrode conductive material includes the planar conductive material and the linear conductive material and satisfies the composition and ratio described above, respectively, so the life characteristics of an existing lithium secondary battery are not significantly affected, and particularly, the number of points where charging and discharging are possible increases when the planar conductive material and the linear conductive material are included, so that output characteristics are excellent at a high C-rate and an amount of gas generation at high temperatures is reduced.

In an exemplary embodiment of the present application, the negative electrode conductive material may be composed of a linear conductive material.

In particular, when a linear conductive material is used alone, the electrode tortuosity, which is a problem of silicon-based negative electrodes, can be simplified, making it possible to improve the electrode structure, and accordingly, to reduce the migration resistance of lithium ions in the electrode.

In an exemplary embodiment of the present application, when the negative electrode conductive material includes a linear conductive material alone, the linear conductive material may be included in an amount of 0.1 part by weight or more and 5 parts by weight or less, preferably 0.2 part by weight or more and 3 parts by weight or less, and more preferably 0.4 part by weight or more and 1 part by weight or less on the basis of 100 parts by weight of the negative electrode composition.

The negative electrode conductive material according to the present application has a completely different configuration from that of a positive electrode conductive material that is applied to the positive electrode. That **is,** the negative electrode conductive material according to the present application serves to hold the contact between silicon-based active materials whose volume expansion of the electrode is very large due to charging and discharging, and the positive electrode conductive material serves to impart some conductivity while serving as a buffer when roll-pressed, and is completely different from the negative electrode conductive material of the present invention in terms of configuration and role.

In addition, the negative electrode conductive material according to the present application is applied to a silicon-based active material, and has a completely different configuration from that of a conductive material that is applied to a graphite-based active material. That is, since a conductive material that is used for an electrode having a graphite-based active material simply has smaller particles than the active material, the conductive material has characteristics of improving output characteristics and imparting some conductivity, and is completely different from the negative electrode conductive material that is applied together with the silicon-based active material as in the present invention, in terms of configuration and role.

In an exemplary embodiment of the present application, the planar conductive material that is used as the negative electrode conductive material described above has a different structure and role from those of the carbon-based active material that is generally used as the negative electrode active material. Specifically, the carbon-based active material that is used as the negative electrode active material may be artificial graphite or natural graphite, and refers to a material that is processed into a spherical or point-like shape and used so as to facilitate storage and release of lithium ions.

On the other hand, the planar conductive material that is used as the negative electrode conductive material is a material having a planar or plate-like shape, and may be expressed as plate-like graphite. That is, the planar conductive material is a material that is included in order to maintain a conductive path in the negative electrode active material layer, and refers to a material for securing a conductive path in a planar shape inside the negative electrode active material layer, rather than playing a role in storing and releasing lithium.

That is, in the present application, the use of plate-like graphite as a conductive material means that graphite is processed into a planar or plate-like shape and used as a material for securing a conductive path rather than playing a role in storing or releasing lithium. In this case, the negative electrode active material included together has high-capacity characteristics with respect to storing and releasing lithium, and serves to store and release all lithium ions transferred from the positive electrode.

On the other hand, in the present application, the use of a carbon-based active material as an active material means that the carbon-based active material is processed into a point-like or spherical shape and used as a material for storing or releasing lithium.

That is, in an exemplary embodiment of the present application, artificial graphite or natural graphite, which is a carbon-based active material, has a point-like shape, and a BET specific surface area thereof may satisfy a range of 0.1 $m^2/g$ or greater and 4.5 $m^2/g$ or less. In addition, plate-like graphite, which is a planar conductive material, has a planar shape, and a BET specific surface area thereof may be 5 $m^2/g$ or greater.

In an exemplary embodiment of the present application, the negative electrode binder may include at least one selected from the group consisting of polyvinylidenefluoride-hexafluoropropylene copolymer (PVDF-co-HFP), polyvinylidenefluoride, polyacrylonitrile, polymethylmethacrylate, polyvinyl alcohol, carboxymethylcellulose (CMC), starch, hydroxypropylcellulose, regenerated cellulose, polyvinylpyrrolidone, polytetrafluoroethylene, polyethylene, polypropylene, polyacrylic acid, ethylene-propylene-diene monomer (EPDM), sulfonated EPDM, styrene butadiene rubber (SBR), fluoro rubber, poly acrylic acid, and the above-described materials in which a hydrogen is substituted with Li, Na, Ca, etc., and may also include various copolymers thereof.

The negative electrode binder according to an exemplary embodiment of the present application serves to hold the active material and the conductive material in order to prevent distortion and structural deformation of the negative electrode structure during volume expansion and relaxation of the silicon-based active material. When such roles are satisfied, all of the general binders can be applied. Specifically, an aqueous binder may be used, and more specifically, a PAM-based binder may be used.

In an exemplary embodiment of the present application, the negative electrode binder may be included in an amount of 30 parts by weight or less, preferably 25 parts by weight or less, and more preferably 20 parts by weight or less, and 5 parts by weight or more, and 10 parts by weight or more on the basis of 100 parts by weight of the negative electrode composition.

In an exemplary embodiment of the present application, there is provided a negative electrode for a lithium secondary battery including: a negative electrode current collector layer; and a negative electrode active material layer including the negative electrode composition according to the present application or a cured product thereof formed on one surface or both surfaces of the negative electrode current collector layer.

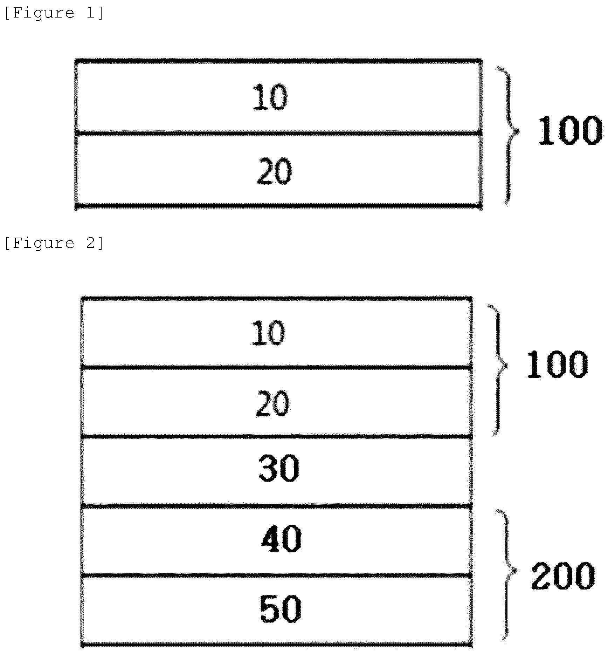

FIG. 1 is a view showing a stack structure of a negative electrode for a lithium secondary battery according to an exemplary embodiment of the present application. Specifically, a negative electrode 100 for a lithium secondary battery can be seen which includes a negative electrode active material layer 20 on one surface of a negative electrode current collector layer 10. FIG. 1 shows that the negative electrode active material layer is formed on one surface of the negative electrode current collector layer, but the negative electrode active material layer may be formed on both surfaces of the negative electrode current collector layer.

In an exemplary embodiment of the present application, the negative electrode for a lithium secondary battery may be formed by applying and drying a negative electrode slurry including the negative electrode composition to one surface or both surfaces of the negative electrode current collector layer.

In this case, the negative electrode slurry may include the negative electrode composition described above, and a slurry solvent.

In an exemplary embodiment of the present application, a solid content of the negative electrode slurry may satisfy a range of 5% or more and 40% or less.

In another exemplary embodiment, the solid content of the negative electrode slurry may satisfy a range of 5% or more and 40% or less, preferably 7% or more and 35% or less, and more preferably 10% or more and 30% or less.

The solid content of the negative electrode slurry may mean a content of the negative electrode composition included in the negative electrode slurry, and may mean a content of the negative electrode composition based on 100 parts by weight of the negative electrode slurry.

When the solid content of the negative electrode slurry satisfies the above range, the viscosity is appropriate during formation of the negative electrode active material layer, so that particle agglomeration of the negative electrode composition is minimized to efficiently form the negative electrode active material layer.

In an exemplary embodiment of the present application, the slurry solvent may be used without limitation as long as it can dissolve the negative electrode composition, and specifically, water or NMP may be used.

In an exemplary embodiment of the present application, the negative electrode current collector layer generally has a thickness of 1 $\mu$m to 100 $\mu$m. Such a negative electrode current collector layer is not particularly limited as long as it has high conductivity without causing a chemical change in the battery. For example, copper, stainless steel, aluminum, nickel, titanium, fired carbon, copper or stainless steel each surface-treated with carbon, nickel, titanium, silver, or the like, an aluminum-cadmium alloy, or the like may be used. In addition, the negative electrode current collector layer may have microscopic irregularities formed on a surface to enhance a bonding force of the negative electrode active material, and may be used in various forms such as a film, a sheet, a foil, a net, a porous body, a foamed body, or a non-woven fabric body.

In an exemplary embodiment of the present application, there is provided the negative electrode for a lithium secondary battery in which a thickness of the negative electrode current collector layer is 1 $\mu$m or greater and 100 $\mu$m or less and a thickness of the negative electrode active material layer is 5 $\mu$m or greater and 500 $\mu$m or less.

However, the thickness may be variously modified depending on a type and a use of negative electrode used, and is not limited thereto.

In an exemplary embodiment of the present application, a porosity of the negative electrode active material layer may satisfy a range of 10% or greater and 60% or less.

In another exemplary embodiment, the porosity of the negative electrode active material layer may satisfy a range of 10% or greater and 60% or less, preferably 20% or greater and 50% or less, and more preferably 30% or greater and 45% or less.

The porosity varies depending on compositions and contents of the silicon-based active material, the conductive material, and the binder included in the negative electrode active material layer, and in particular, satisfies the range described above when the silicon-based active material and the conductive material are included in the specific compositions and contents according to the present application, so that the electrode has electric conductivity and resistance within appropriate ranges.

An exemplary embodiment of the present application provides a lithium secondary battery including a positive electrode; the negative electrode for a lithium secondary battery according to the present application; a separator provided between the positive electrode and the negative electrode; and an electrolyte.

FIG. 2 is a view showing a stack structure of a lithium secondary battery according to an exemplary embodiment of the present application. Specifically, a negative electrode 100 for a lithium secondary battery including a negative electrode active material layer 20 on one surface of a negative electrode current collector layer 10 can be seen, a positive electrode 200 for a lithium secondary battery including a positive electrode active material layer 40 on one surface of a positive electrode current collector layer 50 can be seen, and the negative electrode 100 for a lithium secondary battery and the positive electrode 200 for a lithium secondary battery are formed in a stack structure with a separator 30 interposed therebetween.

The secondary battery according to an exemplary embodiment of the present specification may particularly include the negative electrode for a lithium secondary battery described above. Specifically, the secondary battery may include a negative electrode, a positive electrode, a separator interposed between the positive electrode and the negative electrode, and an electrolyte, and the negative electrode is the same as the negative electrode described above. Since the negative electrode has been described above, a detailed description thereof is omitted.

The positive electrode may include a positive electrode current collector and a positive electrode active material layer formed on the positive electrode current collector and including the positive electrode active material.

In the positive electrode, the positive electrode current collector is not particularly limited as long as it has conductivity without causing a chemical change in the battery. For example, stainless steel, aluminum, nickel, titanium, fired carbon, aluminum or stainless steel each surface-treated with carbon, nickel, titanium, silver, or the like, or the like may be used. In addition, the positive electrode current collector may typically have a thickness of 3 to 500 $\mu$m, and a surface of the current collector may be formed with microscopic irregularities to enhance adhesive force of the positive electrode active material. For example, the positive electrode current collector may be used in various forms such as a film, a sheet, a foil, a net, a porous body, a foamed body, and a non-woven fabric body.

The positive electrode active material may be a positive electrode active material that is typically used. Specifically, the positive electrode active material may be a layered compound such as a lithium cobalt oxide ($LiCoO_2$) and a lithium nickel oxide ($LiNiO_2$), or a compound substituted with one or more transition metals; a lithium iron oxide such as $LiFe_3O_4$; a lithium manganese oxide such as chemical formula $LiI_{1+c1}Mn_{2-c1}O_4(0\leq c1\leq 0.33)$, $LiMnO_3$, $LiMn_2O_3$ and $LiMnO_2$; a lithium copper oxide ($Li_2CuO_2$); a vanadium oxide such as $LiV_3O_8$, $V_2O_5$ and $Cu_2V_2O_7$; a Ni-site type lithium nickel oxide represented by chemical formula $LiNi_{1-c2}M_{c2}O_2$ (where M is at least one selected from the group consisting of Co, Mn, Al, Cu, Fe, Mg, B, and Ga, and satisfies $0.01\leq c2\leq 0.3$); a lithium manganese composite oxide represented by chemical formula $LiMn_{2-c3}M_{c3}O_2$ (where M is at least one selected from the group consisting of Co, Ni, Fe, Cr, Zn and Ta, and satisfies $0.01\leq c3\leq 0.1$) or $Li_2Mn_3MO_8$ (where M is at least one selected from the group consisting of Fe, Co, Ni, Cu and Zn); $LiMn_2O_4$ in which a part of Li of the chemical formula is substituted with an alkaline earth metal ion, or the like, but is not limited thereto. The positive electrode may be Li metal.

The positive electrode active material layer may include a positive electrode conductive material and a positive electrode binder, together with the positive electrode active material described above.

In this case, the positive electrode conductive material is used to impart conductivity to the electrode, and can be used without particular limitation as long as the positive electrode conductive material has electronic conductivity without causing a chemical change in a battery to be constituted. Specific examples may include graphite such as natural graphite and artificial graphite; a carbon-based material such as carbon black, acetylene black, Ketjen black, channel black, furnace black, lamp black, thermal black and carbon fiber; metal powders or metal fibers such as copper, nickel, aluminum and silver; a conductive whisker such as zinc oxide and potassium titanate; a conductive metal oxide such as titanium oxide; or a conductive polymer such as polyphenylene derivative, or the like, and any one thereof or a mixture of two or more thereof may be used.

In addition, the positive electrode binder serves to improve bonding between particles of the positive electrode active material and adhesive force between the positive electrode active material and the positive electrode current collector. Specific examples may include polyvinylidene fluoride (PVDF), vinylidene fluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, polytetrafluoroethylene, polyethylene, polypropylene, ethylene-propylene-diene polymer (EPDM), sulfonated-EPDM, styrene butadiene rubber (SBR), fluoro rubber, or various copolymers thereof, and the like, and any one thereof or a mixture of two or more thereof may be used.

The separator serves to separate the negative electrode and the positive electrode and to provide a migration path of lithium ions, in which any separator may be used as the separator without particular limitation as long as it is typically used in a secondary battery, and particularly, a separator having high moisture-retention ability for an electrolyte as well as a low resistance to the migration of electrolyte ions may be preferably used. Specifically, a porous polymer film, for example, a porous polymer film manufactured from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. In addition, a usual porous non-woven fabric, for example, a non-woven fabric formed of high melting point glass fibers, polyethylene terephthalate fibers, or the like may be used. Furthermore, a coated separator including a ceramic component or polymer material may be used so as to secure heat resistance or mechanical strength, and a separator having a single layer or multilayer structure may be selectively used.

Examples of the electrolyte may include an organic liquid electrolyte, an inorganic liquid electrolyte, a solid polymer electrolyte, a gel-type polymer electrolyte, a solid inorganic electrolyte, or a molten-type inorganic electrolyte that may be used in the manufacturing of the lithium secondary battery, but are not limited thereto.

Specifically, the electrolyte may include a non-aqueous organic solvent and a metal salt.

As the non-aqueous organic solvent, for example, an aprotic organic solvent such as N-methyl-2-pyrrolidinone, propylene carbonate, ethylene carbonate, butylene carbonate, dimethyl carbonate, diethyl carbonate, gamma-butyrolactone, 1,2-dimetoxy ethane, tetrahydrofuran, 2-methyltetrahydrofuran, dimethyl sulfoxide, 1,3-dioxolane, formamide, dimethylformamide, dioxolane, acetonitrile, nitromethane, methyl formate, methyl acetate, phosphoric acid triester, trimethoxy methane, dioxolane derivative, sulfolane, methyl sulfolane, 1,3-dimethyl-2-imidazolidinone, propylene carbonate derivative, tetrahydrofuran derivative, ether, methyl propionate, or ethyl propionate may be used.

In particular, among the carbonate-based organic solvents, ethylene carbonate and propylene carbonate, which are cyclic carbonates, are high-viscosity organic solvents and can be preferably used because they have high permittivity to dissociate a lithium salt well. When the cyclic carbonate is mixed with a linear carbonate with low viscosity and low permittivity, such as dimethyl carbonate and diethyl carbonate, in a suitable ratio and used, an electrolyte having high electric conductivity may be prepared, and therefore, such a combined use may be more preferable.

A lithium salt may be used as the metal salt, and the lithium salt is a material that is readily soluble in the non-aqueous electrolyte, in which, for example, one or more species selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$ and $(CF_3CF_2SO_2)_2N^-$ may be used as an anion of the lithium salt.

One or more additives, for example, a haloalkylene carbonate-based compound such as difluoroethylene carbonate, pyridine, triethylphosphite, triethanolamine, cyclic ether, ethylenediamine, n-glyme, hexamethyl phosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte for the purpose of improving life characteristics of the battery, suppressing a decrease in battery capacity, improving discharge capacity of the battery, and the like, in addition to the above-described electrolyte components.

An exemplary embodiment of the present invention provides a battery module including the secondary battery as a unit cell, and a battery pack including the same. Since the battery module and the battery pack include the secondary battery having high capacity, high-rate capability, and high cycle characteristics, the battery module and the battery pack may be used as a power source of a medium to large sized device selected from the group consisting of an electric vehicle, a hybrid electric vehicle, a plug-in hybrid electric vehicle, and a power storage system.

Hereinafter, preferred examples will be provided for better understanding of the present invention. It will be apparent to one skilled in the art that the examples are only provided to illustrate the present invention, and various modifications and alterations are possible within the scope and technical spirit of the present invention. Such modifications and alterations naturally fall within the scope of claims included herein.

Mode for Invention

**<Preparation Examples>**

**<Preparation of Silicon-based Active Materials>**

**<Example 1>**

MG-Si was pulverized to form primary silicon-based particles in the form of single crystal or polycrystal with a particle size (crystal grain size) of about 100 nm. Then, the primary silicon-based particles and PAA as a binder were mixed in a weight ratio of 9:1 using water as a solvent. The obtained slurry was then spray dried to form granules, resulting in preparation of a silicon-based active material in the form of secondary particles with a D50 of 5 um.

**<Example 2>**

MG-Si was pulverized to form primary silicon-based particles in the form of single crystal or polycrystal with a particle size (crystal grain size) of about 100 nm. Then, the primary silicon-based particles and PAM as a binder were mixed in a weight ratio of 9:1 using water as a solvent. The obtained slurry was then spray dried to form granules, resulting in preparation of a silicon-based active material in the form of secondary particles with a D50 of 5 $\mu$m.

**<Example 3>**

MG-Si was pulverized to form primary silicon-based particles in the form of single crystal or polycrystal with a particle size (crystal grain size) of about 100 nm. Then, the primary silicon-based particles and PVP as a binder were mixed in a weight ratio of 9:1 using water as a solvent. The obtained slurry was then spray dried to form granules, resulting in preparation of a silicon-based active material in the form of secondary particles with a D50 of 5 $\mu$m.

**<Example 4>**

MG-Si was pulverized to form primary silicon-based particles in the form of single crystal or polycrystal with a particle size (crystal grain size) of about 100 nm. Then, the primary silicon-based particles and PAA as a binder were mixed in a weight ratio of 10:1.5 using water as a solvent. The obtained slurry was then spray dried to form granules, resulting in preparation of a silicon-based active material in the form of secondary particles with a D50 of 5 $\mu$m.

**<Example 5>**

MG-Si was pulverized to form primary silicon-based particles in the form of single crystal or polycrystal with a particle size (crystal grain size) of about 100 nm. Then, the primary silicon-based particles and PAA as a binder were mixed in a weight ratio of 10:0.5 using water as a solvent. The obtained slurry was then spray dried to form granules, resulting in preparation of a silicon-based active material in the form of secondary particles with a D50 of 5 $\mu$m.

**<Comparative Example 1>**

MG-Si was mechanically crushed using a jaw crusher or roll crusher, followed by pulverization using a jet mill, which uses centrifugal force and inter-particle collisions. Then, the particle size was controlled using a classifier, resulting in primary silicon-based particles with a size of about 5 $\mu$m, in the form of single crystal or polycrystal.

**<Comparative Example 2>**

A silicon-based active material was deposited on a substrate by chemically reacting silane gas, and then obtained. Then, the particle size was controlled using a classifier, resulting in silicon-based particles with a particle size of about 5 $\mu$m.

**<Comparative Example 3>**

A silicon-based active material was prepared in the same manner as in Example 1 except that, in Example 1, the primary silicon-based particles and PAA as a binder were mixed in a weight ratio of 10:2.5 using water as a solvent.

**<Comparative Example 4>**

A silicon-based active material was prepared in the same manner as in Example 1 except that, in Example 1, the primary silicon-based particles and PAA as a binder were mixed in a weight ratio of 10:0.2 using water as a solvent.

**<Preparation of Negative Electrode>**

A negative electrode active material including each of the silicon-based active material of the Examples and the Comparative Examples, a first conductive material, a second conductive material, and polyacrylamide as a binder were added to distilled water serving as a solvent for formation of a negative electrode slurry in a weight ratio of 80:9.6:0.4:10 to prepare a negative electrode slurry (solid concentration: 25 wt%).

Specifically, the first conductive material was plate-like graphite (specific surface area: 17 m$^2$/g, average particle diameter (D50): 3.5 $\mu$m), and the second conductive material was SWCNT.

As a specific mixing method, after dispersing the first conductive material, the second conductive material, the binder and water at 2500 rpm for 30 minutes with a homo mixer, the silicon-based active material was added to the dispersion, which was then dispersed at 2500 rpm for 30 minutes to prepare a negative electrode slurry.

The negative electrode slurry was coated on both surfaces of a copper current collector (thickness: 8 $\mu$m) serving as a negative electrode current collector with a loading amount of 85 mg/25 cm$^2$, which was then roll-pressed and dried in a vacuum oven at 130°C for 10 hours to form a negative electrode active material layer (thickness: 33 $\mu$m), whereby a negative electrode was prepared (thickness of negative electrode: 41 $\mu$m, porosity of negative electrode: 40.0%).

### <Preparation of Secondary Battery>

A positive electrode slurry (solid concentration: 78 wt%) was prepared by adding LiNi$_{0.6}$Co$_{0.2}$Mn$_{0.2}$O$_2$ (average particle diameter (D50): 15 $\mu$m) as a positive electrode active material, carbon black (product name: Super C65, manufacturer: Timcal) as a conductive material, and polyvinylidene fluoride (PVdF) as a binder to N-methyl-2-pyrrolidone (NMP) as a solvent for formation of a positive electrode slurry at a weight ratio of 97:1.5:1.5.

The positive electrode slurry was coated on both surfaces of an aluminum current collector (thickness: 12 $\mu$m) serving as a positive electrode current collector with a loading amount of 537 mg/25 cm$^2$, which was then roll-pressed and dried in a vacuum oven at 130°C for 10 hours to form a positive electrode active material layer (thickness: 65 $\mu$m), resulting in preparation of a positive electrode (thickness of positive electrode: 77 $\mu$m, porosity: 26%).

A lithium secondary battery was manufactured by interposing a polyethylene separator between the positive electrode and the negative electrode of the Examples and the Comparative Examples and injecting an electrolyte.

The electrolyte was obtained by adding vinylene carbonate to an organic solvent, in which fluoroethylene carbonate (FEC) and diethyl carbonate (DEC) were mixed at a volume ratio of 10:90, in an amount of 3 wt% based on a total weight of the electrolyte and adding LiPF$_6$ as a lithium salt to a concentration of 1M.

### <Experimental Example>

### Experimental Example 1: Results of Monocell Life Performance

For the secondary batteries including the negative electrodes manufactured in the Examples and Comparative Examples, the life and capacity retention rate were evaluated using an electrochemical charging and discharging device. The in-situ cycle test was conducted on the secondary battery at 4.2-3.0 V 1 C/0.5 C, and during the test, 0.33 C/0.33 C charging/discharging (4.2-3.0 V) was performed every 50 cycles to measure the capacity retention rate, and results thereof are listed in Table 1.

life retention rate (%) = {(discharge capacity in the Nth cycle)/(discharge capacity in the first cycle)} $\times$ 100

[Table 1]

|  | Life retention rate (%) after 200 cycles |
|---|---|
| Example 1 | 90 |
| Example 2 | 89 |
| Example 3 | 91 |
| Example 4 | 88 |
| Example 5 | 86 |
| Comparative Example 1 | 82 |
| Comparative Example 2 | 84 |
| Comparative Example 3 | 84 |
| Comparative Example 4 | 83 |

As can be seen in Table 1, it could be confirmed that the life retention rates of the negative electrodes of Examples 1 to 5 according to the present application were higher than those of Comparative Examples 1 to 4. In Examples 1 to 3, the type of binder was changed, and in Examples 4 and 5, its content was changed. In Comparative Examples 3 and 4 where the content of the binder exceeded the upper limit or was below the lower limit of the optimum range, it could be confirmed that when the content of the binder exceeded the upper limit, the capacity retention rate decreased compared to the Examples due to a decrease in the ratio of active material, and when the binder content was less than the lower limit, the ratio of active material increased, but the fine particles increased, resulting in a decrease in the capacity retention rate. In addition, in Comparative Examples 1 and 2 where the single-particle silicon-based active material was used alone, it could be confirmed that there was no material acting as a buffer in the silicon-based active material, resulting in the pulverization phenomenon not being mitigated and a decrease in the life performance.

**Experimental Example 2: Change in Monocell Resistance**

In the test in Experimental Example 1, the capacity retention rates were measured by charging/discharging (4.2-3.0V) the batteries at 0.33C/0.33C every 50 cycles, and then the resistance increase rates were compared and analyzed by discharging the batteries with a pulse of 2.5C at SOC50 to measure the resistance.

For the evaluation of the resistance increase rate measurement, data at 200 cycles was each calculated, and the results are shown in Table 2 below.

[Table 2]

|  | Resistance increase rate (%) after 200 cycles |
|---|---|
| Example 1 | 7 |
| Example 2 | 7 |
| Example 3 | 5 |
| Example 4 | 10 |
| Example 5 | 8 |
| Comparative Example 1 | 20 |
| Comparative Example 2 | 16 |
| Comparative Example 3 | 15 |
| Comparative Example 4 | 17 |

Table 2 above shows the change in resistance. As with Table 1, there was no difference in resistance in Examples 1 to 3. When the content of the binder exceeded the upper limit, an increase in resistance due to the binder was confirmed. Additionally, it could be confirmed that the resistance increase rate in Examples 1 to 5 was lower compared to cases where the content of the binder was below the lower limit or where no binder was included. That is, it could be confirmed through the above experiments that the binder constituting the secondary particles (a mixture of silicon-based particles and a binder) was included in an amount of 1 part by weight or more and 15 parts by weight or less based on 100 parts by weight of the silicon-based active material, thereby serving as a buffer in the silicon-based active material and further mitigating the particle pulverization phenomenon compared to micro-sized polycrystalline particles to improve the life performance and resistance characteristics.

**Claims**

1. A negative electrode active material comprising a silicon-based active material,

   wherein the silicon-based active material is a mixture of silicon-based particles and a binder,
   wherein the silicon-based particles have a crystal grain size of 100 nm or less,
   wherein a particle size (D50) of the silicon-based active material is 1 $\mu$m or greater and 20 $\mu$m or less, and
   wherein the binder is included in an amount of 1 part by weight or more and 15 parts by weight or less based on 100 parts by weight of the silicon-based active material.

2. The negative electrode active material of claim 1, wherein the silicon-based active material comprises one or more selected from the group consisting of $SiO_x$ (x=0) and $SiO_x$ (0<x<2) and comprises $SiO_x$ (x=0) in an amount of 70 parts by weight or more based on 100 parts by weight of the silicon-based active material.

3. The negative electrode active material of claim 1, wherein the silicon-based particles are single-crystal silicon-based particles, or polycrystalline silicon-based particles.

4. The negative electrode active material of claim 1, wherein the silicon-based particles have a crystal grain size of 10 nm or greater and 80 nm or less.

5. The negative electrode active material of claim 1, wherein the binder is a binder having a linear chain structure.

6. The negative electrode active material of claim 1, wherein the binder comprises an aqueous binder, and wherein the aqueous binder comprises one or more selected from the group consisting of polyvinylpyrrolidone (PVP), poly acrylic acid (PAA), and polyacrylamide (PAM).

7. A method for manufacturing a negative electrode active material, the method comprising:

   preparing a silicon raw material;
   pulverizing the silicon raw material to form silicon-based particles; and
   mixing the silicon-based particles with a solvent and a binder to form a silicon-based active material,
   wherein the silicon-based particles have a crystal grain size of 100 nm or less,
   wherein a particle size (D50) of the silicon-based active material is 1 $\mu$m or greater and 20 $\mu$m or less, and
   wherein the binder is included in an amount of 1 part by weight or more and 15 parts by weight or less based on 100 parts by weight of the silicon-based active material.

8. The method of claim 7, further comprising, after mixing the silicon-based particles with a solvent and a binder, drying the mixture.

9. The method of claim 7, wherein in the mixing the silicon-based particles with a solvent and a binder to form a silicon-based active material, a mixing rpm is 2000 rpm or higher and 3000 rpm or less.

10. A negative electrode composition comprising:

    the negative electrode active material of any one of claims 1 to 6;
    a negative electrode conductive material; and
    a negative electrode binder.

11. The negative electrode composition of claim 10, wherein the negative electrode active material is included in an amount of 40 parts by weight or more based on 100 parts by weight of the negative electrode composition.

12. The negative electrode composition of claim 10, wherein the negative electrode conductive material comprises a planar conductive material and a linear conductive material.

13. A negative electrode for a lithium secondary battery, comprising:

    a negative electrode current collector layer; and
    a negative electrode active material layer provided on one surface or both surfaces of the negative electrode current collector layer,
    wherein the negative electrode active material layer comprises the negative electrode composition of claim 10 or a cured product thereof.

14. The negative electrode for a lithium secondary battery of claim 13, wherein a thickness of the negative electrode current collector layer is 1 $\mu$m or greater and 100 $\mu$m or less, and
    wherein a thickness of the negative electrode active material layer is 5 $\mu$m or greater and 500 $\mu$m or less.

15. A lithium secondary battery comprising:

    a positive electrode;
    the negative electrode for a lithium secondary battery of claim 13;
    a separator provided between the positive electrode and the negative electrode; and
    an electrolyte.

[Figure 1]

| 10 |
|---|
| 20 |

} 100

[Figure 2]

| 10 |
|---|
| 20 |

} 100

| 30 |
|---|

| 40 |
|---|
| 50 |

} 200

## INTERNATIONAL SEARCH REPORT

International application No.

**PCT/KR2024/009931**

### A. CLASSIFICATION OF SUBJECT MATTER

**H01M 4/38**(2006.01)i; **H01M 4/62**(2006.01)i; **H01M 4/131**(2010.01)i; **H01M 10/052**(2010.01)i; **H01M 4/134**(2010.01)i; **H01M 4/02**(2006.01)i

According to International Patent Classification (IPC) or to both national classification and IPC

### B. FIELDS SEARCHED

Minimum documentation searched (classification system followed by classification symbols)

H01M 4/38(2006.01); C01B 32/05(2017.01); H01M 10/052(2010.01); H01M 4/134(2010.01); H01M 4/36(2006.01); H01M 4/48(2010.01); H01M 4/58(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 실리콘(silicon), 음극 활물질(anode active material), 바인더(binder), 결정 립(crystal grain), 입도(diameter)

### C. DOCUMENTS CONSIDERED TO BE RELEVANT

| Category* | Citation of document, with indication, where appropriate, of the relevant passages | Relevant to claim No. |
|---|---|---|
| X | KR 10-2023-0096193 A (OCI COMPANY LTD.) 30 June 2023 (2023-06-30)<br>See claims 1, 3, 7-9, 11 and 14; and paragraphs [0003], [0006], [0060], [0072], [0073], [0125], [0126], [0130], [0145], [0188]-[0190] and [0212]-[0215]. | 1-15 |
| A | KR 10-2023-0058287 A (LG ENERGY SOLUTION, LTD.) 03 May 2023 (2023-05-03)<br>See claims 1-17. | 1-15 |
| A | CN 113795943 A (NINGDE AMPEREX TECHNOLOGY LTD.) 14 December 2021 (2021-12-14)<br>See claims 1-13. | 1-15 |
| A | KR 10-2018-0091156 A (KOREA INSTITUTE OF CERAMIC ENGINEERING AND TECHNOLOGY) 16 August 2018 (2018-08-16)<br>See claims 1-15. | 1-15 |

✓ Further documents are listed in the continuation of Box C.  ✓ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **25 October 2024** | **27 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/009931** |

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2022-0083974 A (GUANGDONG KAIJIN NEW ENERGY TECHNOLOGY CO., LTD.) 21 June 2022 (2022-06-21)<br>See claims 1-10. | 1-15 |

Form PCT/ISA/210 (second sheet) (July 2022)

**INTERNATIONAL SEARCH REPORT**
Information on patent family members

International application No.

**PCT/KR2024/009931**

| Patent document cited in search report | | | Publication date (day/month/year) | Patent family member(s) | | | Publication date (day/month/year) |
|---|---|---|---|---|---|---|---|
| KR | 10-2023-0096193 | A | 30 June 2023 | CN | 118355523 | A | 16 July 2024 |
| | | | | JP | 2024-527129 | A | 19 July 2024 |
| | | | | TW | 202327150 | A | 01 July 2023 |
| | | | | WO | 2023-121089 | A1 | 29 June 2023 |
| KR | 10-2023-0058287 | A | 03 May 2023 | EP | 4283711 | A1 | 29 November 2023 |
| | | | | JP | 2024-508116 | A | 22 February 2024 |
| | | | | KR | 10-2601530 | B1 | 14 November 2023 |
| | | | | US | 2023-0125989 | A1 | 27 April 2023 |
| | | | | WO | 2023-068601 | A1 | 27 April 2023 |
| CN | 113795943 | A | 14 December 2021 | JP | 2024-501525 | A | 12 January 2024 |
| | | | | US | 2023-0343943 | A1 | 26 October 2023 |
| | | | | WO | 2022-140981 | A1 | 07 July 2022 |
| KR | 10-2018-0091156 | A | 16 August 2018 | KR | 10-1906163 | B1 | 10 October 2018 |
| KR | 10-2022-0083974 | A | 21 June 2022 | CN | 112563503 | A | 26 March 2021 |
| | | | | CN | 113193201 | A | 30 July 2021 |
| | | | | JP | 2023-509253 | A | 08 March 2023 |
| | | | | JP | 7357699 | B2 | 06 October 2023 |
| | | | | US | 2022-0181608 | A1 | 09 June 2022 |
| | | | | WO | 2022-121281 | A1 | 16 June 2022 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230091763
- JP 2009080971 A